# FASCICULE DE BREVET EUROPEEN

(11) **EP 3 465 748 B1**
(45) Date de publication et mention de la délivrance du brevet: **12.05.2021**
(21) Numéro de dépôt: 17728196.1
(22) Date de dépôt: 06.06.2017
(51) Int. Cl.: H01L 23/29, H01L 23/31, H01L 21/56

(54) **PROCÉDÉ DE TRAITEMENT D'UN MATÉRIAU ÉLECTRIQUEMENT ISOLANT POUR COMPOSANTS ÉLECTRIQUES, COMPOSANT ÉLECTRIQUE FABRIQUÉ PAR CE PROCÉDÉ ET DISPOSITIF DE TRAITEMENT D'UN MATÉRIAU ÉLECTRIQUEMENT ISOLANT**
VERFAHREN ZUR VERARBEITUNG EINES ELEKTRISCH ISOLIERENDEN MATERIALS FÜR ELEKTRISCHE KOMPONENTEN, NACH DIESEM VERFAHREN HERGESTELLTES ELEKTRISCHES KOMPONENT UND VORRICHTUNG ZUR VERARBEITUNG EINES ELEKTRISCH ISOLIERENDEN MATERIALS
METHOD FOR PROCESSING AN ELECTRICALLY INSULATING MATERIAL FOR ELECTRICAL COMPONENTS, ELECTRICAL COMPONENT MANUFACTURED BY THIS METHOD AND APPARATUS FOR PROCESSING AN ELECTRICALLY INSULATING MATERIAL

(30) Priorité: 06.06.2016 FR 1655173
(43) Date de publication de la demande: 10.04.2019
(73) Titulaire: Université Toulouse III-Paul Sabatier, 31062 Toulouse Cedex 9 (FR); Centre National de la Recherche Scientifique, 75016 Paris 16 (FR); Institut National Universitaire Jean-Francois Champollion, 81012 ALBI Cedex 09 (FR)
(72) Inventeur: BELIJAR, Guillaume, 31400 TOULOUSE (FR); DIAHAM, Sombel, 31620 VILLENEUVE LES BOULOC (FR); LEBEY, Thierry, 31000 TOULOUSE (FR); LEVEQUE, Louis, 29470 PLOUGASTEL DAOULAS (FR); VALDEZ NAVA, Zarel, 31450 FOURQUEVAUX (FR); LAUDEBAT, Lionel, 31180 CASTELMAUROU (FR)
(74) Mandataire: Vidon Brevets & Stratégie
(86) Numéro de dépôt international: PCT/EP2017/063740
(87) Numéro de publication internationale: WO 2017/211847

(56) Documents cités:
- JP-A- H0 731 044
- US-A1- 2001 014 413
- US-A1- 2004 140 116
- US-A1- 2008 102 266

## Description

### 1. DOMAINE DE L'INVENTION

L'invention s'inscrit dans le domaine des matériaux isolants électriques pour composants électriques. Plus précisément, l'invention concerne une technique de traitement d'un matériau de protection électriquement isolant destiné à recouvrir un composant électrique à isoler.

L'invention s'applique notamment, mais non exclusivement, aux systèmes d'électronique, d'électronique de puissance ou d'électrotechnique destinés à la conversion, au transport de l'énergie électrique haute tension ou aux composants électriques embarqués (tels que les convertisseurs de puissance, les transformateurs haute tension, les commutateurs à gaz isolant, les connecteurs haute tension, les éléments pour la transmission en haute tension, les câbles haute tension que ce soit en DC (« *Direct Current* ») ou AC (« *Alternative Current* »), les bus-bars, par exemple).

Le terme « *composant électrique* » dans ce document doit être interprété au sens large et peut correspondre aussi bien à un module électrique ou électronique, un circuit électrique ou électronique, un circuit imprimé de type PCB, une carte électrique ou électronique, un composant électronique, un connecteur électrique, un câble électrique, etc. Plus généralement, l'invention peut s'appliquer à tout élément à fonctionnalité électrique ou électronique doté de contacts électriques destiné à être recouvert par un isolant électrique.

### 2. ARRIÈRE-PLAN TECHNOLOGIQUE

On s'attache plus particulièrement dans la suite de ce document à décrire la problématique existant dans le domaine de l'électronique de puissance, à laquelle ont été confrontés les inventeurs. L'invention ne se limite bien sûr pas à ce domaine particulier d'application, mais présente un intérêt pour toute technique de protection électrique (encapsulation, passivation, tropicalisation, émaillage, imprégnation, moulage, etc.) devant faire face à une problématique proche ou similaire.

L'isolation électrique est un élément critique dans les dispositifs fonctionnant sous haute tension. La durée de vie d'un composant électrique étant souvent liée à la durée de vie de son isolation, des recherches ont été menées ces dernières années pour comprendre les causes de dégradation et de vieillissement des matériaux utilisés comme isolants électriques solides, et en particulier dans les modules d'électronique de puissance. Ces derniers fonctionnant sous haute tension sont soumis en effet à de fortes contraintes électriques, pouvant conduire à l'apparition de renforcements de champ électrique dans le matériau isolant (i.e. zones singulières à proximité des éléments conducteurs autour desquelles le champ électrique est plus intense). Ces renforcements de champ sont -sous conditions que certains niveaux de tension soient atteints- sources de décharges partielles, détériorant le composant au fur et à mesure de son utilisation, voire de claquage électrique.

Ceci est d'autant plus remarquable que les matériaux isolants utilisés dans les composants de puissance actuels endurent des contraintes pour lesquels ils n'ont pas été forcément dimensionnés. En effet, la montée en tension de fonctionnement combinée à la forte augmentation de l'intégration de l'électronique dans les systèmes embarqués notamment, conduit à une augmentation de la densité de puissance. De ce fait, le niveau de contraintes électriques à endurer pour les matériaux isolants se trouve démultiplié.

Une solution pour garantir une meilleure tenue en tension consisterait à surdimensionner les éléments constitutifs des composants électriques, mais cette démarche n'est évidemment pas compatible avec une recherche d'optimisation d'intégration.

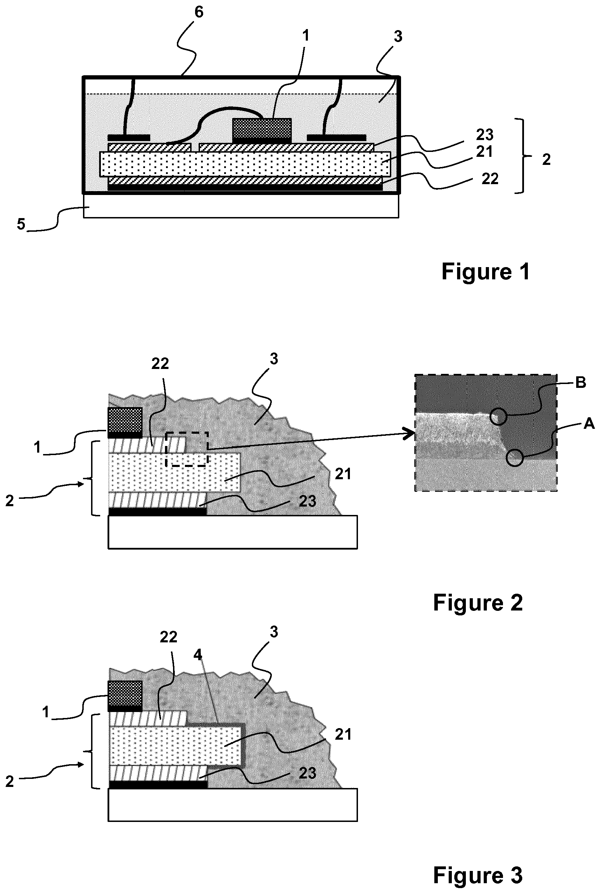

Un composant fréquemment utilisé dans les systèmes de conversion d'énergie pour le transport ferroviaire par exemple, est le module de puissance à puces IGBT (pour « *Insulated Gate Bipolar Transistor* » *ou* transistors bipolaire à grille isolée), comme illustré sur la **figure 1****.** Sa structure est constituée d'un empilement de différents éléments. Une ou plusieurs puces IGBT 1 sont brasées sur un substrat isolant 2 comprenant une couche électriquement isolante 21 (à base d'un matériau céramique) laquelle est recouverte sur ses faces inférieure et supérieure d'un contact électrique métallique 22 et 23 (métallisation). Le substrat 2 est un substrat céramique métallisé appelé DBC (pour « *Direct Bonding Copper* ») ou AMB (pour *« Active Metal Brazing* ») du fait du procédé par lequel il est obtenu. Dans le cas le plus courant, ce dernier est disposé sur un support 5 en cuivre ou en AlSiC. Les différents éléments du module sont assemblés et recouverts d'une couche de matériau électriquement isolant 3 (encapsulant), puis enfermés dans un boîtier plastique 6. Le module est ensuite fixé à un système de refroidissement face inférieure du module (non représenté), afin de dissiper la chaleur produite en fonctionnement, puis relié par des conducteurs au reste du circuit électrique (actionneurs, sources, etc.).

Une des principales causes de défaillance d'un point de vue électrique de ce type de composant réside dans la rupture de l'isolation électrique au niveau du point triple céramique/métal/isolant, comme illustré sur la **figure 2** (point triple noté A) correspondant à l'interface de trois milieux de permittivités différentes, et au niveau de la pointe du contact électrique 22 (référencé B) à l'interface métal/isolant (on parle dans ce cas d'« *effet de pointe* »). Ces points sensibles sont liés principalement à la géométrie des contacts qui sont obtenus après gravure et provoquent une non-uniformité du champ électrique dans le matériau d'encapsulation. Un renforcement de champ électrique localisé dans l'isolant au voisinage de ces points sensibles peut conduire à la formation de décharges électriques partielles, se manifestant parfois sous la forme d'arborescences électriques, dont la répétition dégrade le matériau d'encapsulation 3, entraînant un vieillissement prématuré du module, ainsi que des problèmes de fiabilité, ou une limitation de la tenue en tension.

Dans une optique de montée en tension et/ou d'intégration de l'électronique de puissance tout en conservant des contraintes de tensions élevées, une solution connue, décrite dans le document de brevet WO 2015/074431, et illustrée sur la **figure 3****,** consiste à déposer une couche mince de vernis semi-résistif 4 à base de silicium amorphe hydrogéné sur la couche de céramique 21 à l'interface avec le matériau d'encapsulation 3 depuis le contact électrique supérieur 22 jusqu'au contact électrique inférieur 23. Cette couche de vernis semi-résistif 4 permet de réduire le risque de décharges partielles situées autour des contacts électriques. Toutefois, une telle solution nécessite l'utilisation d'un équipement de dépôt par plasma qui est coûteux et difficilement industrialisable. De plus, le masquage de certains éléments sensibles au sein de la structure est relativement complexe au vu de la variation des éléments structurels qui peuvent le composer.

Une autre solution connue, décrite dans la publication scientifique de N. Hayakawa, et Al., 2012, intitulée « Fabrication Technique of Permittivity Graded Materials (FGM) for Disk-Type Solid Insulator, Proceedings of the CEIDP », repose sur la réalisation d'un matériau gradateur de potentiel (ou gradateur de champ électrique) en tant que matériau d'encapsulation électriquement isolant pour composants électroniques. La gradation de potentiel est effectuée par un matériau à gradient de permittivité. Celui-ci est un composite à base d'une matrice polymère chargée en particules de tailles différentes. Ce composite, avant d'être durci, est soumis à une force centrifuge de façon à provoquer le déplacement des particules dans la matrice polymère pour obtenir un certain profil de permittivité en fonction de la distribution spatiale des particules.

Toutefois, cette solution présente un certain nombre d'inconvénients. Du fait de la nature de la technique utilisée pour déplacer les particules dans la matrice polymère (centrifugation), seul un déplacement unilatéral des particules dans la matrice est possible (dans le sens opposé au centre de rotation du matériau), ce qui n'est pas optimal. Cette technique est restrictive car elle ne permet de traiter qu'une unique zone localisée du matériau (et non forcément l'intégralité des zones qu'il conviendrait de traiter (l'absence de décharges partielles dans le matériau n'est donc pas garantie)), et implique en outre que le matériau ait une forme géométrique simple (cylindrique ou circulaire). Cette solution requiert de plus un ré-usinage du matériau d'encapsulation postérieurement aux étapes de centrifugation et de durcissement, ce qui est fastidieux et coûteux à mettre en œuvre. Enfin, elle ne semble pas compatible pour la fabrication de composants électriques volumineux, comme les modules de puissance, les transformateurs ou appareils de coupure haute tension par exemple.

Pour réduire les problèmes de renforcement du champ électrique au voisinage des contacts électriques, il est également connu, comme décrit dans le document de brevet japonais JP H0731044, d'utiliser un champ électrique au cours de l'élaboration du matériau de protection.

Il apparaît donc nécessaire de proposer une solution innovante d'isolation électrique qui permette de réduire de manière efficace le phénomène de décharges partielles dans un composant électrique et/ou de monter en tension de fonctionnement, et qui soit simple et peu coûteuse à mettre en œuvre.

### 3. EXPOSÉ DE L'INVENTION

Dans un mode de réalisation particulier de l'invention, il est proposé un procédé de traitement d'un matériau de protection électriquement isolant destiné à recouvrir au moins une surface d'un composant électrique à isoler comprenant deux contacts électriques, le procédé comprenant les étapes telles que définies dans la revendication 1.

Le principe général de l'invention consiste donc à utiliser un champ électrique au cours de l'élaboration du matériau de protection à base d'une matrice hôte électriquement isolante chargée en particules de permittivité diélectrique supérieure, pour lui conférer des propriétés de gradation de champ électrique auto-adaptatives. En effet, les inventeurs ont découvert que l'application d'un champ électrique à un tel mélange composite homogène provoque le déplacement des particules dans la matrice hôte de telle sorte qu'elles se concentrent naturellement dans les zones à traiter (c'est-à-dire dans les zones où des renforcements de champ électrique indésirables peuvent apparaître lorsque le composant est sous tension). Ceci induit une augmentation de la permittivité diélectrique et/ou de la conductivité électrique de manière ciblée et automatiquement adaptée aux défauts du composant électrique. Ainsi, contrairement à l'état de la technique (où seul un déplacement unilatéral des particules dans la matrice est possible), le procédé de l'invention offre une solution simple et efficace basée sur un auto-ajustement du profil de permittivité diélectrique et/ou de conductivité électrique du matériau de protection au cours de son élaboration en fonction des points critiques réellement présents dans le matériau. Le matériau composite hétérogène obtenu présente donc un profil de permittivité diélectrique et/ou de conductivité électrique réduisant les renforcements de champ électrique, sources de décharges partielles du composant électrique en fonctionnement. Le procédé de traitement selon l'invention permet donc de garantir une meilleure tenue en tension du composant électrique et par conséquent une durée de vie augmentée.

Selon une mise en œuvre particulière, le procédé comprend en outre une étape de durcissement du mélange composite postérieurement à l'étape d'application d'un champ électrique.

Cette étape de durcissement permet de figer la distribution spatiale des particules obtenues dans la matrice hôte après traitement électrique. A l'issue de cette étape, on obtient un matériau de protection électriquement isolant et gradateur de champ électrique.

Selon une variante de mise en œuvre, le procédé comprend une étape de durcissement du mélange composite qui est mise en œuvre au cours de l'étape d'application d'un champ électrique.

Cette étape de durcissement permet de figer la distribution spatiale des particules obtenue dans la matrice hôte pendant le traitement électrique. A l'issue de cette étape, on obtient un matériau de protection électriquement isolant et gradateur de champ électrique. Cette implémentation particulière est avantageuse en termes de temps car elle permet de réaliser un traitement double en parallèle du mélange composite.

Dans une implémentation particulière, qui ne fait pas partie de la présente invention, le champ électrique appliqué est un champ électrique continu.

Cette implémentation particulière permet de moduler efficacement le profil de concentration des particules dans la matrice hôte. Elle peut être mise en œuvre par exemple pour obtenir un gradient de concentration de particules à partir de l'interface entre le contact électrique et le matériau de protection.

Selon une caractéristique particulière, le composant électrique comprend un premier contact électrique de potentiel haut et un deuxième contact électrique de potentiel bas, le champ électrique étant appliqué à l'aide d'une différence de potentiel de polarité prédéterminée (polarité positive ou négative) entre lesdits premier et deuxième contacts.

Cela permet de privilégier une concentration de particules sur l'un ou l'autre des contacts électriques dans le cas où un champ électrique continu est appliqué. Par exemple une concentration de particules à l'interface avec un contact d'alimentation électrique haute tension pourra être privilégiée puisque le risque de renforcements de champ électrique autour de ce contact sera probablement plus important.

Selon la présente invention, le champ électrique appliqué est un champ électrique alternatif avec une fréquence inférieure ou égale à 10 Hz.

Le champ électrique alternatif permet de moduler efficacement le profil de concentration des particules dans la matrice hôte et est particulièrement bien adaptée au composant électrique présentant une configuration à renforcement symétrique. Le champ électrique peut être appliqué au moyen d'un signal électrique alternatif de forme carrée, triangulaire, sinusoïdale ou analogue.

Selon une implémentation qui ne fait pas partie de la présente invention, le champ électrique est appliqué avec une fréquence strictement supérieure à 10 Hz.

Les inventeurs ont découvert, de manière surprenante, qu'en appliquant un champ électrique « haute fréquence » (c'est-à-dire de fréquence supérieure à 10 Hz), il est possible de former une couche de relaxation du champ électrique s'étendant entre les premier et deuxième contacts sous la forme de chaînes particulaires (cette chaîne de particules étant de permittivité diélectrique relative supérieure à celle du reste du mélange composite hétérogène).

Les inventeurs ont également découvert, de manière surprenante, qu'en appliquant un champ électrique « basse fréquence » (c'est-à-dire de fréquence inférieure ou égale à 10 Hz), on obtient des première et deuxième couches de relaxation du champ électrique disposées de manière symétrique sur les premier et deuxième contacts électriques, respectivement. On entend par « symétrique » le fait que les deux couches de relaxation présentent une forme et une épaisseur similaire, grâce à une distribution symétrique des particules dans le matériau de protection.

Dans cette mise en œuvre, le champ électrique est appliqué au moyen d'un premier signal électrique alternatif de forme prédéterminée, lequel est superposé à un deuxième signal électrique continu.

La présence d'un signal électrique continu superposé à un signal électrique alternatif permet de former de manière asymétrique des première et deuxième couches de relaxation du champ électrique sur les premier et deuxième contacts électriques respectivement. On entend par « asymétrique » le fait que l'une des couches de relaxation créées présente une épaisseur supérieure à l'autre. Le signal électrique alternatif peut être de forme carrée, sinusoïdale, triangulaire ou analogue.

Selon une caractéristique particulière, le champ électrique est appliqué avec une amplitude inférieure à 2 kV/mm. Le champ électrique appliqué est compris plus particulièrement entre 50 et 1000 V, et encore plus particulièrement entre 100 et 500 V.

Selon une caractéristique particulière, la matrice hôte a une permittivité diélectrique relative comprise entre 1 et 20 et la charge particulaire a une permittivité diélectrique supérieure à 2. La permittivité diélectrique relative de la matrice hôte et de la charge particulaire est choisie en particulier de sorte que la permittivité diélectrique relative de la couche de relaxation de champ électrique du mélange composite hétérogène obtenu, est comprise entre 10 et 50, et plus particulièrement aux alentours de 25.

Il convient de noter que la permittivité diélectrique relative de la matrice hôte a été mesurée expérimentalement à l'état solide avec une fréquence de 1 MHz et à une température 25 °C, et celle de la charge particulaire a été mesurée expérimentalement à l'état solide avec une fréquence de 50 Hz et à une température 25 °C.

La matrice hôte est obtenue à partir d'un matériau polymère liquide durcissable et la charge particulaire est obtenue à partir d'un matériau appartenant au groupe comprenant : SrTiO₃, BaTiO₃, Ba₁₋ₓSrₓTiO₃, SiC, Al₂O₃, AlN, BN, Si₃N₄, SiO₂, ZnO, MgO, CaCu₃Ti₄O₁₂, TiO₂, MoS₂, Ca₂Nb₃O₁₀, Si_{w}AlₓO_{y}N_{z}, Polyfluorure de vinylidène (PVDF) ou Polyamide (PA), etc.

Cette liste de matériaux n'est pas exhaustive. A noter que la matrice hôte peut être obtenue à partir d'un matériau polymère liquide polymérisable thermiquement (c'est-à-dire qui présente des caractéristiques de solidification sous l'action d'un traitement thermique) ou photodurcissable (c'est-à-dire qui présente des caractéristiques de solidification sous l'action d'un rayonnement électromagnétique). A noter également que la charge particulaire peut être obtenue à partir d'un des matériaux listés ci-dessus ou une combinaison de ces matériaux.

Selon une caractéristique particulière, le rapport en volume de la charge particulaire par rapport au volume total du mélange composite homogène est compris entre 0,01 et 60%, et plus particulièrement entre 10 et 60%. Dans certains cas particuliers, on peut envisager un rapport en volume compris entre 60 et 70%.

Cette gamme de rapport en volume a montré de bons résultats pour conférer au matériau de protection les caractéristiques désirées.

Selon une caractéristique particulière, la charge particulaire est une charge à base de particules de taille micrométrique et/ou nanométrique.

Selon une caractéristique particulière, la charge particulaire est une charge à base de particules de forme sphérique et/ou cylindrique et/ou tubulaire et/ou planaire.

La taille et la forme des particules peuvent avoir un impact sur la permittivité et/ou la conductivité électrique du matériau d'encapsulation final, sur sa rigidité diélectrique et sur le seuil d'apparition et l'endurance aux décharges partielles.

Selon une caractéristique particulière, la charge particulaire est une charge à base de particules ayant une structure composite de type noyau-enveloppe.

Ainsi, la charge particulaire peut comprendre soit des particules homogènes dans leur composition chimique soit des particules composites avec une structure de type noyau-enveloppe (ou « *core-shell* » en anglais), ou bien une combinaison des deux.

Selon une caractéristique particulière, ladite étape d'application d'un champ électrique est effectuée au moyen d'une partie de connexion externe du composant électrique coopérant avec ledit au moins un contact électrique.

Cette caractéristique est particulièrement avantageuse puisque la présence de la partie de connexion externe permet de réaliser le traitement électrique du matériau d'encapsulation avec les éléments structurels du composant électrique lui-même. Dans certains cas, ceci évite d'avoir recours à un système d'électrode supplémentaire venant en contact avec ledit au moins un contact électrique, et qui plus est, nécessiterait de devoir modifier l'architecture structurelle, pour certains composants électriques à structure interne complexe, pour pouvoir réaliser cette étape. Dans d'autres cas, l'ajout d'une contre-électrode temporaire et amovible dédiée uniquement à l'application du champ électrique durant le procédé peut être envisagé. Le procédé selon l'invention est donc simple et peu coûteux à mettre en œuvre comparativement aux procédés de l'état de la technique.

Selon une variante de réalisation, ladite étape d'application d'un champ électrique est effectuée au moyen d'au moins une contre-électrode temporaire et amovible destinée à être connectée électriquement audit au moins un contact électrique.

Cette variante peut être utilisée par exemple lorsque le composant électrique ne possède pas de partie de connexion externe coopérant avec ledit au moins un contact électrique où si ladite partie de connexion externe n'est pas facile d'accès.

Il est proposé un procédé de fabrication d'un composant électrique, comprenant une étape de réalisation d'un composant électrique à isoler, et une étape de traitement d'un matériau de protection électriquement isolant tel que décrit précédemment, dans l'un quelconque de ses modes de réalisation.

Dans un autre mode de réalisation de l'invention, il est proposé un composant électrique tel que défini dans la revendication 10.

Dans un autre mode de réalisation de l'invention, il est proposé un dispositif de traitement d'un matériau de protection électriquement isolant destiné à recouvrir au moins une surface d'un composant électrique à isoler tel que défini dans la revendication 13.

### 4. LISTE DES FIGURES

D'autres caractéristiques et avantages de l'invention apparaîtront à la lecture de la description suivante, donnée à titre d'exemple indicatif et non limitatif, et des dessins annexés, dans lesquels :
- la figure 1, déjà décrite en relation avec l'art antérieur, présente un exemple de module électrique de puissance connu de l'état de la technique ;
- la figure 2, déjà décrite en relation avec l'art antérieur, présente une vue partielle en coupe du module électrique illustré à la figure 1 ;
- la figure 3, déjà décrite en relation avec l'art antérieur, présente une technique connue pour réduire la formation de décharges partielles dans un module de puissance tel que celui présenté en relation avec les figures 1 et 2 ;
- la figure 4 présente un organigramme d'un mode de réalisation particulier du procédé qui est utile à la compréhension de la présente invention;
- la figure 5 est un schéma synoptique simplifié représentant les différentes étapes d'un procédé connu de l'état de la technique ;
- les figures 6A et 6B sont des vues en coupe partielles d'une structure de type DBC, obtenues au microscope optique après traitement du matériau de protection selon le procédé de la figure 5 ;
- la figure 7 est un schéma synoptique simplifié représentant les différentes étapes d'un autre procédé connu de l'état de la technique ;
- la figure 8 est une vue en coupe partielle d'une structure de type DBC, obtenue au microscope optique après traitement du matériau de protection selon le procédé de la figure 7 ;
- les figures 9 et 10 sont des schémas synoptiques simplifiés représentant les étapes du procédé selon des première et deuxième mises en œuvre particulières de l'invention;
- les figures 11 et 12 représentent des exemples de chronogrammes du champ électrique alternatif appliqué dans le cadre des mises en œuvre particulières illustrées aux figures 9 et 10.

### 5. DESCRIPTION DÉTAILLÉE

Sur toutes les figures du présent document, les éléments et étapes identiques sont désignés par une même référence numérique.

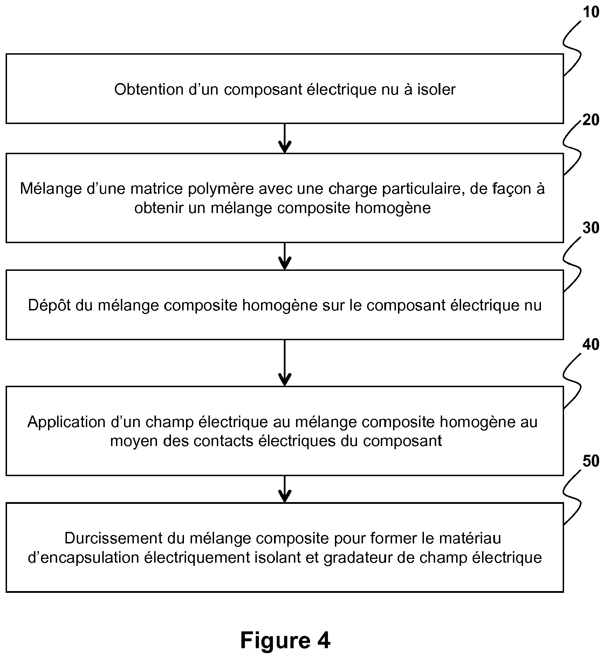

On décrit ci-après, en relation avec la **figure 4****,** les étapes principales du procédé de fabrication d'un composant électrique selon un mode de réalisation particulier de l'invention.

### Etape 10 de réalisation d'un composant électrique à isoler

On procède tout d'abord à la réalisation d'un composant électrique nu. Par exemple, cette étape 10 dans le cas d'un module de puissance à transistors IGBT ou JFET (« *Junction Field Effect Transistor* »), qui n'a pas encore été électriquement isolé, est réalisée au moyen d'une technique de lithographie ou d'autres techniques bien connues issues de la microélectronique.

Pour simplifier les figures et la description associée, on se focalise ici sur une partie seulement du module de puissance, à savoir le substrat céramique métallisé ou substrat *DBC* (« *Direct Bonding Copper* ») dudit module. On utilisera indifféremment dans la suite les termes «composant» ou « module » pour désigner le même élément structurel.

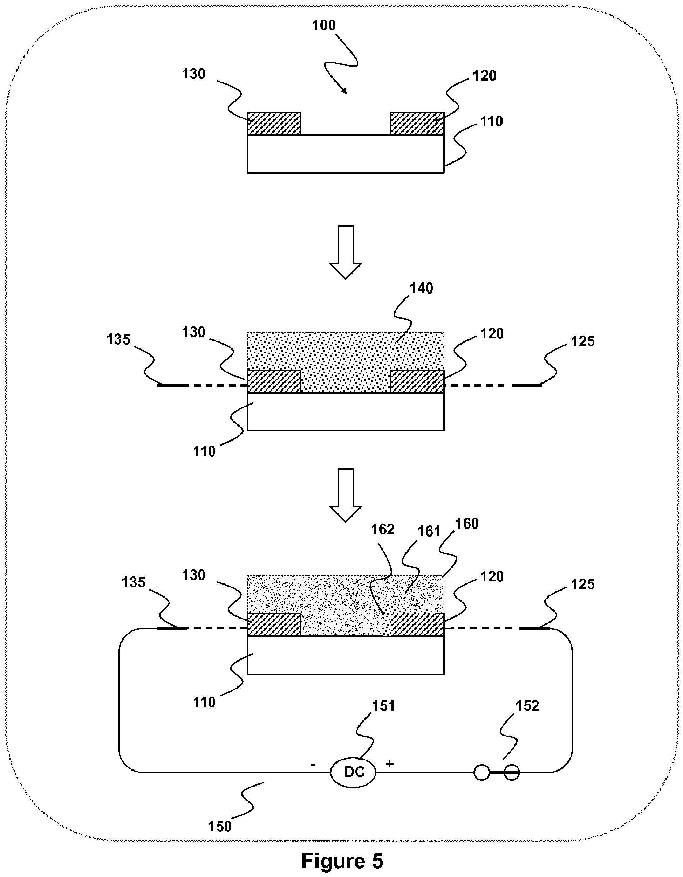

Comme illustré sur la figure 5, le composant à isoler 100 comprend une couche de matériau céramique 110 (par exemple une couche d'oxyde d'aluminium, de formule chimique Al₂O₃) sur laquelle est agencée un premier contact électrique 120, de potentiel haut, reliée à une alimentation haute tension, et un deuxième contact électrique 130, de potentiel bas, relié à la masse. Le composant à isoler 100 comprend également un autre contact électrique (non illustré sur la figure) agencé sur la face inférieure de la couche de matériau céramique 110 et relié à la masse. Ces éléments forment le substrat céramique métallisé. Le composant à isoler 100 comprend en outre un support en cuivre (Cu) ou en alliage aluminium-carbure de silicium (AlSiC), couramment appelé semelle (non illustrée sur la figure) sur laquelle est disposée le substrat céramique métallisé. La couche de matériau céramique 110 a permittivité diélectrique relative d'environ 9.

Les étapes qui suivent ont pour objet de réaliser un matériau de protection (ou d'encapsulation) électriquement isolant destiné à recouvrir le composant à isoler 100, ce matériau étant élaboré de manière à réduire la formation de décharges partielles lorsque le composant est sous tension et/ou de permettre de monter la tension de fonctionnement.

### Etape 20 de réalisation d'un mélange composite homogène durcissable

On réalise tout d'abord un mélange à partir d'une matrice hôte électriquement isolante chargée homogènement en particules invitées, aussi appelées charges particulaires. Dans l'exemple décrit ici, la matrice hôte est une matrice polymère liquide à base d'époxyde, couramment appelée « résine époxy », mélangée à un durcisseur avec un rapport pondéral de polymère/durcisseur de 10:1. La matrice hôte constitue donc un milieu polymérique liquide durcissable. La charge particulaire comprend des particules inorganiques issues d'une poudre de titanate de strontium (SrTiO₃) par exemple. Les particules ont une taille micrométrique comprise typiquement entre 100 nm et 100 micromètres. Des particules de taille nanométrique inférieure à 100 nanomètres peuvent également être utilisées seules ou en combinaison avec des particules de taille micrométrique, sans sortir du cadre de la présente invention. Les particules de titanate de strontium ont été choisies pour leur permittivité diélectrique relative (ou constante diélectrique) élevée (typiquement comprise entre 100 et 400 à l'état massique) par rapport à celle de la matrice polymère époxyde (typiquement comprise entre 3 et 6).

Une quantité donnée de particules micrométriques de titanate de strontium est introduite dans la matrice polymérique époxyde (comprenant le durcisseur), et mélangée au moyen d'un mélangeur planétaire. Le rapport en volume de la charge particulaire par rapport au volume total du composite est de 10% environ.

A l'issue de l'étape 20, on obtient un mélange composite homogène à matrice polymérique époxyde chargée en particules de titanate de strontium, noté Epoxyde/SrTiO₃.

Il s'agit ici d'un exemple purement illustratif et d'autres matériaux remplissant la même fonction peuvent être envisagés sans sortir du cadre de l'invention. De manière générale, pour conférer au final au matériau de protection son comportement gradateur de champ électrique (dit « *Field Grading* » en anglais), on préférera utiliser pour la réalisation de cette étape :
- une matrice polymère organique présentant une permittivité diélectrique relative inférieure ou égale à 20 (mesurée à 1 MHz et à 25 °C à l'état solide), comme par exemple une résine thermodurcissable (polyester ou époxyde, polyimide, polyester-imide ...), thermoplastique (polyéthylène, polyuréthane, ...) ou encore une résine élastomère (gel ou gomme silicone), et
- une charge particulaire présentant une permittivité diélectrique relative strictement supérieure à 2 (mesurée à 50 Hz et à 25 °C à l'état solide), comme par exemple une charge particulaire à base de SrTiO₃, BaTiO₃, Ba₁₋ₓSrₓTiO₃, SiC, Al₂O₃, AlN, BN, Si₃N₄, SiO₂, ZnO, MgO, CaCu₃Ti₄O₁₂, TiO₂, MoS₂, Ca₂Nb₃O₁₀, Si_{w}AlₓO_{y}N_{z}, Polyfluorure de vinylidène (PVDF) ou polyamide (PA) ou une combinaison de ces matériaux, la condition étant que la permittivité diélectrique relative de la charge particulaire doit être strictement supérieure à celle de la matrice hôte.

La charge particulaire peut comprendre des particules de tailles différentes (tailles micrométriques et/ou nanométriques) et de forme sphérique et/ou cylindrique et/ou tubulaire et/ou planaire.

On pourrait envisager également, à titre d'alternative ou en combinaison avec le mode de réalisation décrit ici, d'utiliser des particules à structure composite noyau-enveloppe, aussi appelées « *core-shell* » en anglais. Ces particules sont constituées d'un noyau formé d'un premier matériau, et d'une enveloppe formée d'un second matériau.

On pourrait envisager également, à titre d'alternative ou en combinaison avec le mode de réalisation décrit ici, d'utiliser des particules conductrices d'électricité assimilables à une particule dont la permittivité diélectrique relative est extrêmement élevée (on caractérise généralement les métaux par leurs propriétés de conduction électrique plutôt que de leurs propriétés diélectriques).

De même, le rapport en volume de la charge particulaire introduite initialement dans la matrice par rapport au volume total du composite peut être compris entre 0,01 et 60%. Quant à la viscosité de la résine polymérique époxyde, elle est choisie dans cet exemple dans la plage comprise entre 10 et 10 000 mPa.s à température ambiante (sensiblement égale à 20°C). Mais, plus généralement, elle peut être choisie dans une plage comprise entre 10 et 100 000 mPa.s en fonction des caractéristiques physico-chimiques des matériaux choisis pour composer le mélange composite, ainsi que d'autres paramètres du procédé que l'homme du métier sera à même d'appréhender avec des essais de routine à sa portée (par exemple la viscosité de la résine, l'amplitude et la forme du champ électrique appliqué, la température du procédé, etc. ont un impact sur la vitesse de croissance de la couche de particules dans le matériau de protection).

### Etape 30 de recouvrement

Cette étape consiste à recouvrir le composant à isoler 100 sur la totalité de sa surface avec le mélange composite homogène Epoxyde/SrTiO₃ obtenu à l'issue de l'étape précédente, afin de l'encapsuler. A cette fin, un mélange composite homogène Epoxyde/SrTiO₃ 140 est déposé sur la surface du composant typiquement au moyen d'une technique de dépôt de polymère en voie liquide. Cette technique présente plusieurs avantages : elle est simple à mettre en œuvre, requiert un faible coût d'équipement, permet de réaliser des couches de grandes surfaces et d'épaisseurs micrométriques ou millimétriques variables. De plus, cette technique est facilement transférable à l'industrie.

Bien entendu, ce mélange composite 140 peut être formé au moyen d'autres techniques de dépôt notamment, mais non exclusivement, par voie chimique (ou CSD pour « *Chemical Solution Deposition* »), trempage (« *dip coating* »), centrifugation (« *spin coating* »), étalement (« *doctor blade coating* »), applicateur (« *meniscus coating* »), pulvérisation (« *spray coating* »), jet d'encre (« *ink jet coating* »), sérigraphie, extrusion, moulage d'injection, moulage, encapsulage, coulage, imprégnation, etc.

A l'issue de cette étape, le composant à isoler 100 est recouvert d'un mélange composite Epoxyde/SrTiO₃ 140.

Cette étape permet non seulement de recouvrir les contacts électriques 120 et 130 comme illustré sur la figure 5, mais également de recouvrir les autres éléments du composant électrique non visibles sur la figure. En effet, dans cette étape, les différents éléments structurels constituant le module de puissance à transistor IGBT doivent être recouverts de cette couche, le but étant d'encapsuler et d'isoler électriquement tous ces éléments.

Seule une partie extérieurement accessible des contacts électriques 120 et 130 (référencées 125 et 135 respectivement sur la figure) n'est pas recouverte par le mélange composite 140 et est accessible depuis l'extérieur du composant pour permettre une connexion électrique ultérieure (étape 40).

### Etape 40 de traitement électrique

Cette étape du procédé selon l'invention consiste à appliquer un champ électrique alternatif de fréquence inférieure ou égale à 10 Hz au mélange composite 140 de façon à provoquer le déplacement des particules de titanate de strontium dans la matrice polymère afin d'obtenir un profil de permittivité diélectrique en fonction de la distribution spatiale des particules adapté aux zones de renforcement de champ que pourrait présenter le matériau de protection sous contrainte électrique. Il est proposé deux techniques particulières pour procéder à ce traitement électrique : une application d'un champ électrique DC (électrophorèse) et une application d'un champ électrique AC (diélectrophorèse). La deuxième technique est décrite postérieurement.

### (i) Application d'un champ électrique DC (életrophorèse)

Dans une implémentation particulière, qui ne fait pas partie de la présente invention, un champ électrique continu (ou plus généralement comprenant une composante continue) est créé entre les contacts électriques 120 et 130 du composant à l'aide de moyens d'application d'un champ électrique continu 150. Ces derniers comprennent par exemple une source de tension continue « DC » 151 configurée pour porter les contacts électriques 120 et 130 à des potentiels électriques différents, et un interrupteur 152 pour appliquer ou non le champ électrique en fonction de sa position (ouverte ou fermée). De manière avantageuse, les pôles de la source de tension 151 sont reliés électriquement aux parties de connexion extérieurement accessibles 125 et 135 du composant électrique.

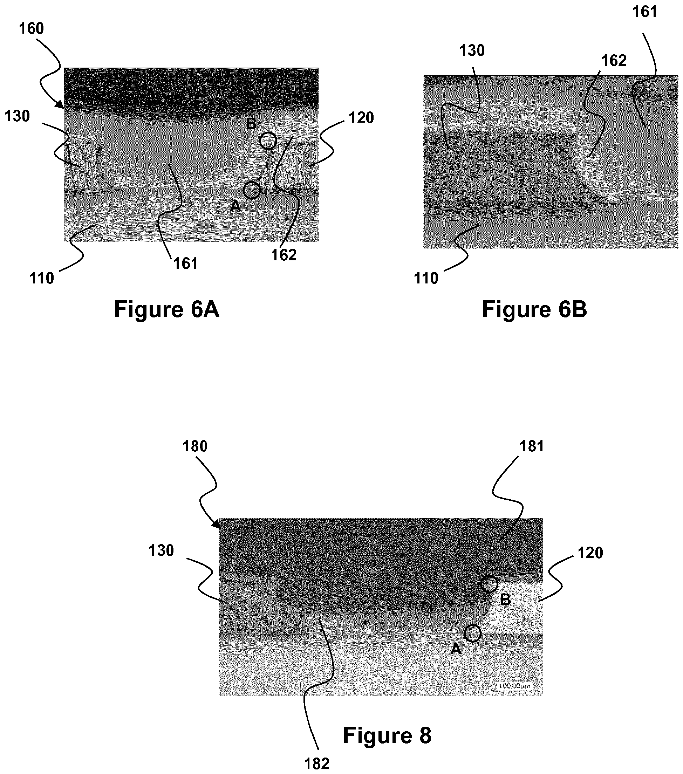

En pratique, une tension électrique continue d'amplitude 500 V est appliquée par exemple entre les contacts électriques 120 et 130 distants de 1mm (soit un champ électrique de 500 V/mm), pendant une durée d'environ 15 minutes. Cette tension électrique est générée en appliquant une différence de potentiel positive (par exemple + 500 V) entre le contact électrique 120 (connecté à la haute tension) et le contact électrique 130 (connecté à la masse). Cette configuration en polarité positive permet de provoquer le déplacement des particules de titanate de strontium vers le contact électrique de potentiel haut 120 (i.e. vers le contact d'alimentation haute tension) et de se concentrer sensiblement autour de celui-ci, comme illustré sur la **figure 6A****.**

Bien entendu, on pourrait envisager, à titre d'alternative, d'appliquer un champ électrique continu entre les contacts 120 et 130 avec une configuration en polarité négative (c'est-à-dire en appliquant un signal de tension négatif, par exemple - 500 V, au contact électrique 120), de façon à provoquer le déplacement des particules de titanate de strontium vers le contact électrique de potentiel bas 130, comme cela est illustré sur la **figure 6B****.**

Ainsi, de façon astucieuse, il est possible d'accumuler les particules préférentiellement soit du côté de la métallisation haute tension, soit du côté de la métallisation masse en fonction de la polarité du champ électrique appliqué.

On obtient à l'issue de cette étape de traitement électrique, un mélange composite hétérogène en termes de distribution spatiale des particules (et donc en termes de permittivité diélectrique du matériau).

Le matériau de protection 160 obtenu par le procédé comprend une première partie composite 161 présentant une concentration faible en particules de SrTiO₃ et une deuxième partie composite 162 plus fortement chargée en particules de SrTiO₃, accumulées sous la forme d'une couche dite de relaxation du champ électrique. L'épaisseur de la couche de relaxation du champ électrique 162 est ajustable, pour une concentration de particules donnée, en fonction notamment du niveau du champ électrique appliqué, de la durée d'application de ce champ, de la viscosité de la matrice hôte de départ, de la taille, de la forme et de la nature des particules invitées.

De manière générale, un champ électrique continu appliqué avec une amplitude comprise entre 100 et 500 V/mm pendant une durée comprise entre 1 et 60 minutes a montré de bons résultats. De manière encore plus générale, on pourrait appliquer une tension électrique continue d'amplitude inférieure à 2 000 V, et plus particulièrement comprise entre 50 et 1 000 V. L'amplitude du champ électrique peut être adaptée notamment en fonction de la distance inter-électrode (distance séparant les deux contacts électrique 120 et 130) pour obtenir la couche de relaxation désirée (épaisseur, concentration, etc.).

Des essais à la portée de l'homme du métier permettent de sélectionner les paramètres et matériaux les plus appropriés en fonction de la distribution spatiale des particules souhaitée et des propriétés de gradation de champ électrique souhaitées au final pour le matériau de protection.

Comme illustré sur la figure 6A, on s'aperçoit que l'utilisation d'un champ électrique continu au cours de l'élaboration du matériau de protection a pour effet en particulier de concentrer les particules de titanate de strontium localement autour du contact électrique « haute tension » 120. Cette distribution spatiale des particules de SrTiO₃ permet de former une couche de permittivité diélectrique augmentée à l'interface entre le matériau de protection 160 et le contact électrique 120 (interface isolant/métal). Ce qui est particulièrement intéressant c'est que cette couche, qui s'est créée de manière autonome par processus électrophorétique, couvre de façon privilégiée les points de plus grande fragilité connus du matériau tels que le point triple A céramique/métal/isolant et la pointe B du contact électrique. Les résultats expérimentaux et les simulations menées par les inventeurs ont montré que cette distribution spatiale des particules de SrTiO₃ a pour effet de diminuer le gradient de permittivité diélectrique aux interfaces métal/isolant et donc de réduire la formation des renforcements de champ au voisinage des points A et B.

Par exemple, les matériaux de la matrice hôte et de la charge particulaire sont choisis de sorte que les première et deuxième parties composites 161 et 162 du matériau de protection 160 présentent une permittivité diélectrique relative aux alentours de 12 et de 25 respectivement. Plus généralement, la matrice hôte et la charge particulaire sont choisies de sorte que : la matrice hôte présente une permittivité diélectrique relative comprise entre 1 et 20 et la charge particulaire présente une permittivité diélectrique relative supérieure à 2, et préférentiellement supérieur à 11, de telle sorte que la permittivité diélectrique relative de la couche de relaxation 162 obtenue après traitement soit comprise entre 10 et 50.

Le procédé de traitement précité permet donc de garantir la fabrication d'un composant électrique ayant une meilleure tenue en tension électrique, moins de décharges partielles et par conséquent une durée de vie augmentée. Ainsi, les inventeurs ont utilisé un champ électrique continu appliqué au mélange composite pour permettre de répartir de manière totalement autonome les particules au niveau des zones à traiter (zones présentant des renforcements de champ électrique). En effet, du fait de la nature électrique du traitement, le profil de concentration des particules dans le composite suit naturellement la répartition et les renforcements du champ électrique induits durant le traitement. L'utilisation d'un traitement électrique est donc particulièrement astucieuse. Une augmentation locale de permittivité diélectrique est induite naturellement là où cela est nécessaire, et de façon auto-structurante comme le montre les figures 6A et 6B. Cette auto-structuration est particulièrement avantageuse car elle peut permettre d'épouser d'autres défauts qui seraient impossibles à prévoir lors de la fabrication du composant électrique, comme la présence d'une singularité (ou effet de pointe) par exemple, et qui se situerait en dehors des zones sensibles habituelles.

### (ii) Application d'un champ électrique AC (diélectrophorèse).

### a) Application d'un champ électrique AC « haute fréquence »

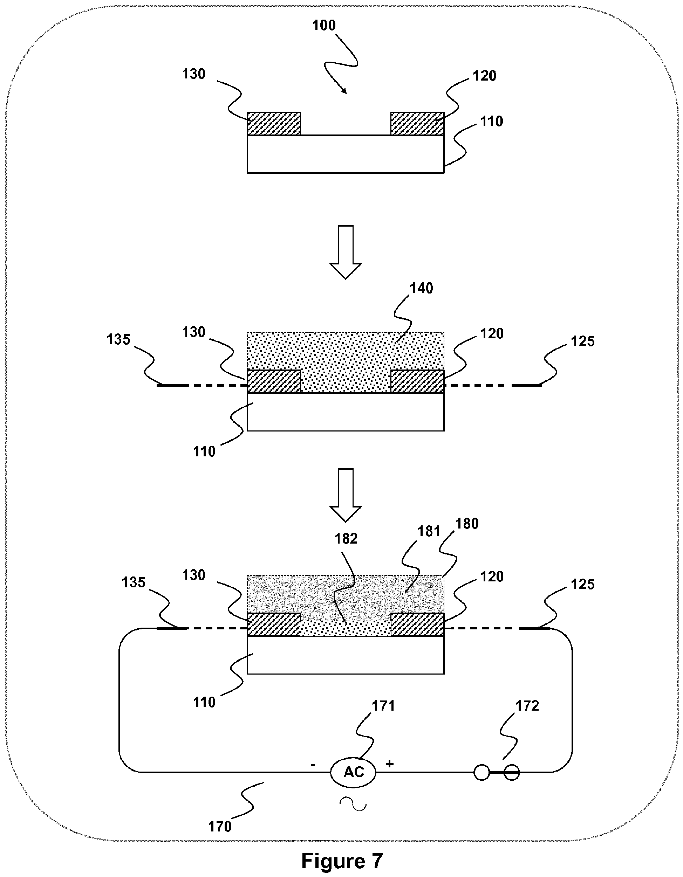

Dans l'exemple illustré à la **figure 7****,** qui ne fait pas partie de la présente invention, un champ électrique alternatif est créé entre les contacts électriques 120 et 130 du composant à l'aide des moyens d'application d'un champ électrique alternatif 170. Ces derniers comprennent par exemple une source de tension alternative « AC » 171 configurée pour porter les contacts électriques 120 et 130 à des potentiels électriques différents et à une fréquence donnée, et un interrupteur 172 permettant d'appliquer ou non le champ électrique en fonction de sa position (ouverte ou fermée). De manière avantageuse, les pôles de la source de tension 171 sont reliés électriquement aux parties de connexion extérieurement accessibles 125 et 135 du composant.

Dans l'exemple illustré ici, une tension électrique alternative sinusoïdale d'amplitude 500 V et fréquence 1 kHz est appliquée entre les contacts électriques 120 et 130 distants de 1mm, pendant une durée d'environ 15 minutes. Bien entendu, il s'agit d'un exemple illustratif, et d'autres valeurs de tension, fréquence et durée de traitement peuvent être envisagées. On pourrait envisager d'appliquer une tension électrique alternative sinusoïdale d'amplitude inférieure à 2 000 V, plus particulièrement comprise entre 50 et 1000 V, et encore plus particulièrement entre 100 et 500 V. On adaptera le champ électrique notamment en fonction de la distance inter-électrode (distance séparant les deux contacts électriques 120 et 130).

Toutefois, il est à noter que pour former une couche de relaxation 182 sous cette forme spécifique de chaînes particulaires strictement s'étendant entre les contacts électriques 120 et 130, le champ électrique alternatif doit être appliqué avec une haute fréquence, c'est-à-dire strictement supérieure à 10 Hz. Plus particulièrement, la fréquence peut être comprise entre 11 et 100 kHz.

Comme pour le premier mode de réalisation, l'étape 50 de traitement thermique peut également s'effectuer soit postérieurement à l'étape 40 soit au cours de l'étape 40 dans son deuxième mode de réalisation.

Le matériau de protection électriquement isolant et à gradient de permittivité diélectrique 180 comprend une partie composite 181 faiblement concentrée en particules de SrTiO₃ et une partie composite 182 plus fortement chargée en particules de SrTiO₃. Les particules de SrTiO₃ accumulées se présentent sensiblement sous la forme d'une couche 182, dite couche de relaxation du champ électrique, s'étendant entre les contacts électriques 120 et 130. Les propriétés électriques et diélectriques de la couche de relaxation du champ électrique 182 sont ajustables, pour une concentration de particules donnée, en fonction notamment du niveau du champ électrique appliqué, de sa fréquence, de la durée d'application de ce champ, de la viscosité et de la permittivité de la matrice hôte de départ, de la taille, de la forme et de la nature des particules invitées.

De manière générale, un champ électrique alternatif appliqué avec une valeur efficace comprise entre 100 et 500 V/mm, une fréquence comprise entre 11 Hz et 100 kHz pendant une durée comprise entre 1 et 60 minutes a montré de bons résultats. De manière encore plus générale, un champ électrique alternatif appliqué avec une amplitude supérieure ou égale à 1 V/mm dans une gamme de fréquences comprises entre 10 Hz et 10 MHz pendant *a minima* une durée de 1 seconde fonctionne.

Des essais à la portée de l'homme du métier permettent de sélectionner les paramètres et matériaux les plus appropriés en fonction de la distribution spatiale des particules souhaitée, de la permittivité diélectrique de la couche de relaxation du champ électrique souhaitée, et des propriétés de gradation de champ électrique souhaité au final pour le matériau de protection.

Comme illustré sur la **figure 8****,** on s'aperçoit que l'application d'un champ électrique alternatif haute fréquence au cours de l'élaboration du matériau de protection a pour effet en particulier de former des chaînes de particules de titanate de strontium s'étendant le long du substrat céramique 110 entre les contacts électriques 120 et 130. Ainsi, dans ce mode de réalisation particulier, le profil de concentration des particules obtenu est différent puisqu'il permet de former une couche de permittivité diélectrique augmentée de façon anisotrope entre les contacts électriques 120 et 130 du composant. Un tel profil permet d'augmenter de façon efficace la permittivité diélectrique de l'isolant notamment au niveau des points triples des contacts électriques.

Grâce à l'utilisation d'un champ électrique alternatif, il est donc possible d'induire naturellement une augmentation de la permittivité diélectrique du matériau de protection dans les zones à traiter, comme le montre la figure 8. Cette auto-structuration est particulièrement avantageuse car elle permet entre autre de contrecarrer tout défaut qui serait impossible à prévoir lors de la fabrication du composant électrique.

### b) Application d'un champ électrique AC « basse fréquence »

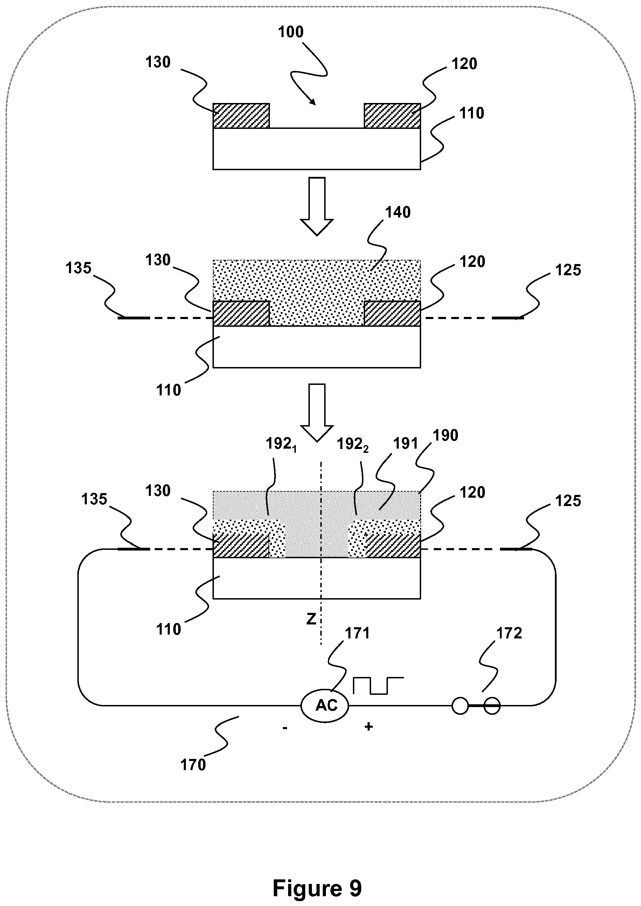

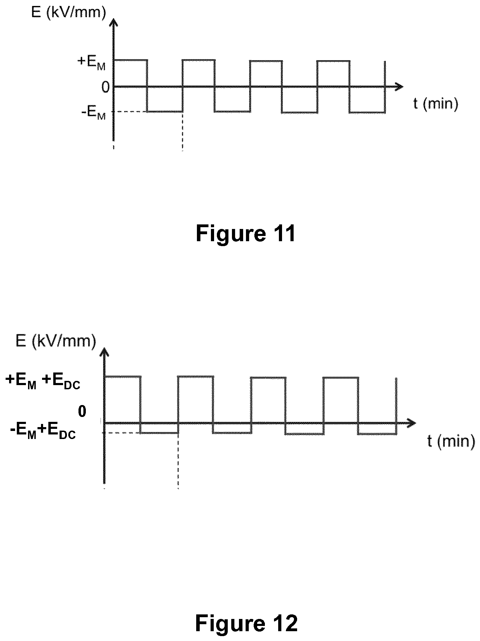

Dans cette première mise en œuvre particulière de l'invention, dont le principe est illustré sur les **figures 9** et **11****,** un champ électrique alternatif basse fréquence est appliqué entre les deux contacts électriques 120 et 130. A la différence du mode de réalisation particulier illustré à la figure 7, le champ électrique alternatif est appliqué ici avec une fréquence égale ou inférieure à 10 Hz.

Le traitement électrique est réalisé ici en appliquant entre les contacts électriques 120 et 130 une tension électrique alternative périodique de forme carrée, d'amplitudes maximale +500 V et minimale - 500 V (soit 1 kV crête-à-crête), et de fréquence 10 mHz, pendant une durée d'environ 15 minutes. Les contacts électriques 120 et 130 sont portés au potentiel haut et à la masse respectivement. La distance inter-électrode est toujours de 1 mm. Le champ électrique résultant est illustré sur le chronogramme de la figure 11 : les valeurs crête-à-crête +E_{M} et -E_{M} correspondent aux valeurs maximale et minimale du champ électrique appliqué au mélange composite. A noter que le champ électrique dans cette variante est symétrique par rapport à l'axe des abscisses qui est égal à 0 kV/mm.

Ce traitement électrique a pour effet de permettre, par déplacement symétrique des particules de SrTiO₃ dans la matrice hôte sur chacun des contacts électriques 120 et 130, la formation de deux couches de relaxation du champ électrique 192₁ et 192₂, d'épaisseurs sensiblement identiques. La première couche de relaxation 192₁ est formée ici en surface du contact électrique 130 et la première couche 192₂ est formée en surface du contact électrique 120. Les deux couches de relaxation 192₁ et 192₂ présentent une permittivité diélectrique relative supérieure à 10, et plus particulièrement entre 20 et 50. Ainsi, après traitement électrique et traitement thermique (ce dernier pouvant être effectué au cours ou postérieurement à l'étape de traitement électrique), le matériau de protection électriquement isolant 190 ainsi obtenu comprend une partie composite 191 faiblement concentrée en particules de SrTiO₃ et deux couches de relaxation 192₁ et 192₂, fortement chargées en particules de SrTiO₃, s'étendant en surface des contacts électriques 130 et 120 respectivement.

Les inventeurs se sont aperçus que, de manière surprenante, l'application d'un champ électrique basse fréquence entre deux contacts électriques au cours de l'élaboration du matériau de protection provoque un déplacement symétrique des particules de SrTiO₃ dans la matrice hôte vers chacun des contacts électriques. Après traitement, les particules de SrTiO₃ présentent un profil de distribution spatiale symétrique par rapport l'axe vertical Z du composant.

Bien entendu, il s'agit d'un exemple illustratif non limitatif. D'autres valeurs de tension électrique, de fréquence et de durée de traitement peuvent être envisagées sans sortir du cadre de l'invention. D'autres formes de signal alternatif peuvent également être envisagées (tel qu'un signal de forme sinusoïdale, triangulaire ou analogue par exemple).

Dans cette variante de réalisation, on pourrait envisager d'appliquer un champ électrique alternatif de fréquence inférieure ou égale à 10 Hz, plus particulièrement inférieure ou égale à 1 Hz, plus particulièrement inférieure ou égale à 0,100 Hz et encore plus particulièrement inférieure ou égale à 0,010 Hz, sans sortir du cadre de l'invention.

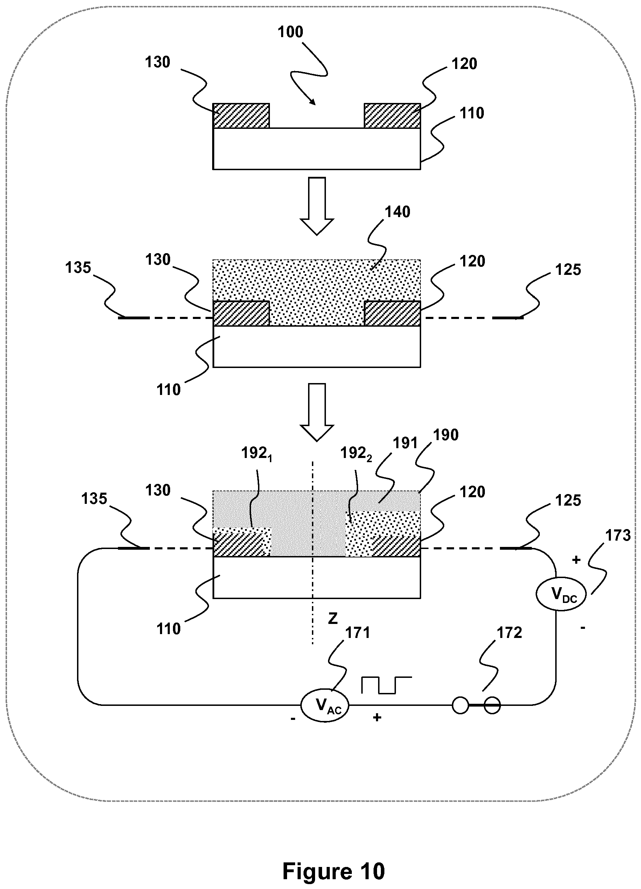

Dans une deuxième mise en œuvre de l'invention particulièrement avantageuse, dont le principe est illustré en relation avec les **figures 10** et **12****,** le champ électrique alternatif est appliqué au moyen d'une combinaison de deux signaux électriques : un premier signal électrique alternatif périodique, de forme prédéterminée (carrée, sinusoïdale ou analogue par exemple), et un deuxième signal électrique continu dit « de modulation ». Ce deuxième signal électrique a pour fonction de moduler l'amplitude du premier signal électrique. Ainsi, à la différence de la première variante de réalisation des figures 9 et 11, le traitement électrique consiste à appliquer une tension électrique alternative périodique mais en présence d'une composante de tension continue supplémentaire (qui peut être positive ou négative de façon à moduler l'amplitude de tension maximale ou minimale du signal alternatif). Cette composante de tension continue a pour effet de rendre le chronogramme du champ électrique appliqué au matériau asymétrique par rapport à l'axe des abscisses, comme illustré sur la figure 12.

Prenons l'exemple d'un signal électrique alternatif périodique de forme carrée (V_{AC}), d'amplitudes maximale + 500 V et minimale - 500 V (soit 1 kV crête-à-crête), et de fréquence 10 mHz, superposé à un signal électrique continu (V_{DC}) d'amplitude + 400 V, les deux signaux électriques étant appliqués pendant une durée d'environ 60 minutes. Pour ce faire, les moyens d'application 170 comprennent une source de tension continue 173 supplémentaire montée en série de la source de tension alternative 171.

Le champ électrique résultant dans cette deuxième mise en œuvre est illustré sur le chronogramme de la figure 12 : les valeurs crête-à-crête « +E_{M} + E_{DC} » et « -E_{M} + E_{DC} » correspondent aux valeurs maximale et minimale du champ électrique appliqué au mélange composite. Le champ électrique ainsi créé est décalé positivement par rapport à l'axe des abscisses d'un « offset » d'amplitude E_{DC} (+ 400 V/mm dans cet exemple), permettant d'obtenir le profil asymétrique des couches de relaxation tel que représenté sur la figure 10.

Comme illustré sur la figure 10, ce traitement électrique particulier a pour effet de déplacer les particules de SrTiO₃ dans la matrice hôte vers les contacts électriques 120 et 130 mais de manière asymétrique. Dans le cas de figure illustré ici (configuration en polarité positive), le signal électrique continu « V_{DC} » est appliqué au contact électrique 120, favorisant ainsi une concentration des particules de SrTiO₃ en surface du contact de haut potentiel électrique 120, plutôt que vers le contact de bas potentiel électrique 110.

Par conséquent, après traitement électrique et traitement thermique (ce dernier pouvant être effectué au cours ou postérieurement à l'étape de traitement électrique), le matériau de protection électriquement isolant 190 comprend une partie composite 191 faiblement concentrée en particules de SrTiO3 et dispose de deux couches de relaxation 192₁ et 192₂, fortement chargées en particules de SrTiO₃, mais d'épaisseurs inégales. Plus précisément, la couche de relaxation 192₂ (côté contact 120) présente une épaisseur supérieure à celle de la couche de relaxation 192₂, (côté contact 110).

Les inventeurs se sont aperçus que, de manière surprenante, l'application d'un champ électrique basse fréquence et asymétrique (du point de vue des potentiels électriques) entre deux contacts électriques provoque un déplacement des particules de SrTiO₃ dans la matrice hôte préférentiellement vers l'un des contacts électriques. Ainsi, comme illustré sur la figure 10, les particules de SrTiO₃ se présentent, après traitement, sous la forme d'un profil de distribution spatiale asymétrique par rapport l'axe vertical Z du composant. La forme asymétrique du profil de distribution spatiale des particules de SrTiO₃ est donc intimement liée à la forme asymétrique du signal électrique alternatif appliqué au matériau au cours de sa fabrication.

Ainsi, en modulant le signal électrique alternatif avec un signal électrique continu additionnel, il est possible d'accumuler de façon ciblée les particules de SrTiO₃ sur un contact électrique plutôt que l'autre. Si aucun signal électrique de modulation (« V_{DC} ») n'est généré, l'épaisseur des deux couches de relaxation cumulées sur les deux contacts électriques est identique, et l'on retrouve le profil de permittivité diélectrique symétrique discuté plus haut en relation avec les figures 9 et 11.

Bien entendu, il s'agit d'un exemple illustratif non limitatif. Comme pour la première variante, d'autres valeurs de tension électrique, de fréquence et de durée de traitement peuvent être envisagées sans sortir du cadre de l'invention. D'autres formes de signal alternatif peuvent également être envisagées (tel qu'un signal de forme sinusoïdale, triangulaire ou analogue par exemple).

### Etape 50 de durcissement

On procède ensuite à un durcissement du mélange composite hétérogène au moyen d'un traitement thermique (aussi appelé recuit de solidification). Pour ce faire, le composant est introduit dans un four, la température est ensuite portée à 150 °C (avec une rampe de 15 °C/min) sous air pendant une durée de 15 minutes. Cette étape est employée pour permettre le durcissement de la matrice hôte liquide par réticulation des molécules polymériques, et donc de figer la distribution spatiale des particules ainsi obtenue à l'issue de l'étape 40. Ici on opère un traitement thermique mais on pourrait très bien envisager d'utiliser à la place d'une matrice polymérique liquide polymérisable thermiquement, un autre type de matrice polymérique liquide réagissant à un traitement par rayonnement électromagnétique (rayonnement UV ou micro-ondes par exemple). Des essais à la portée de l'homme du métier permettront d'établir les paramètres (niveau de température, durée, rampe de montée et descente, source de rayonnement électromagnétique, etc.) de durcissement adaptés aux matrices polymériques liquides choisies.

A l'issue de cette étape, on obtient un matériau de protection (ou d'encapsulation) 160 ou 180 électriquement isolant et gradateur de champ électrique, comme expliqué ci-dessus.

Selon une alternative de mise en œuvre, il est possible d'effectuer l'étape de traitement thermique non pas postérieurement à l'étape 40 comme discuté ci-dessus, mais au cours même de l'étape 40, ce qui est plus optimal en termes de temps de traitement (le traitement thermique et le traitement électrique étant réalisés en parallèle).

Les modes de réalisation décrits ci-dessus proposent d'utiliser les parties de connexion extérieurement accessibles du composant pour appliquer un champ électrique entre les contacts électriques auxquelles elles sont raccordées. Ceci permet de réaliser le traitement électrique *in situ* du matériau de protection avec les éléments structurels du composant électrique lui-même. Cette approche est simple et peu coûteuse à mettre en œuvre. Elle présente également l'avantage de pouvoir s'adapter à tout type de composants électriques, même à structure interne complexe. Toutefois, on pourrait envisager à titre d'alternative que l'application du champ électrique selon l'invention soit réalisée au moyen d'un jeu d'électrodes dédié à relier électriquement aux moyens d'application du champ électrique (par exemple l'ajout d'au moins une contre-électrode temporaire et amovible dédiée uniquement à l'application du champ électrique durant le procédé décrit ci-dessus).

Le procédé décrit ci-dessus est destiné à la fabrication de modules et composants électriques de puissance. Il est clair toutefois qu'il peut aisément être adapté à d'autres applications, sans sortir du cadre de la présente.

## Revendications

1. Procédé de traitement d'un matériau de protection électriquement isolant destiné à recouvrir au moins une surface d'un composant électrique à isoler (100) comprenant des premier et deuxième contacts électriques (120 ; 130), le procédé comprenant les étapes suivantes :
- mélange (20) d'une matrice hôte électriquement isolante avec une charge particulaire de permittivité diélectrique relative supérieure à celle de la matrice hôte, de façon à obtenir un mélange composite homogène ;
- recouvrement (30) du mélange composite homogène sur ladite au moins une surface du composant électrique à isoler ;
le procédé étant **caractérisé en ce qu'**il comprend, postérieurement à ladite étape de recouvrement, une étape d'application (40) d'un champ électrique alternatif, de fréquence inférieure ou égale à 10 Hz, au mélange composite homogène au moyen desdits premier et deuxième contacts électriques, de façon à obtenir un mélange composite hétérogène ayant une partie composite (191) faiblement concentrée en particules et des première et deuxième couches de relaxation de champ électrique (192₁,192₂), plus fortement chargées en particules, s'étendant en surface respectivement desdits premier et deuxième contacts électriques.

2. Procédé selon la revendication 1, **caractérisé en ce qu'**il comprend en outre une étape de durcissement (50) du mélange composite postérieurement à l'étape d'application d'un champ électrique.

3. Procédé selon la revendication 1, **caractérisé en ce qu'**une étape de durcissement (50) du mélange composite est mise en œuvre au cours de l'étape d'application d'un champ électrique.

4. Procédé selon l'une quelconque des revendications 1 à 3, **caractérisé en ce que** le champ électrique est appliqué au moyen d'un premier signal électrique alternatif de forme prédéterminée lequel est superposé à un deuxième signal électrique continu.

5. Procédé selon l'une quelconque des revendications 1 à 4, **caractérisé en ce que** le champ électrique est appliqué avec une amplitude inférieure à 2 kV/mm.

6. Procédé selon l'une quelconque des revendications 1 à 5, **caractérisé en ce que** la matrice hôte a une permittivité diélectrique relative comprise entre 1 et 20 et **en ce que** la charge particulaire a une permittivité diélectrique supérieure à 2.

7. Procédé selon l'une quelconque des revendications 1 à 6, **caractérisé en ce que** ladite étape d'application d'un champ électrique est effectuée au moyen d'une partie de connexion externe du composant électrique coopérant avec l'un desdits premier et deuxième contacts électriques.

8. Procédé selon l'une quelconque des revendications 1 à 7, **caractérisé en ce que** ladite étape d'application d'un champ électrique est effectuée au moyen d'au moins une contre-électrode temporaire et amovible destinée à être connectée à l'un desdits premier et deuxième contacts électriques.

9. Procédé de fabrication d'un composant électrique, comprenant une étape de réalisation d'un composant électrique à isoler, **caractérisé en ce qu'**il comprend une étape de traitement d'un matériau de protection électriquement isolant selon l'une quelconque des revendications 1 à 8.

10. Composant électrique dont au moins une surface est recouverte par un matériau de protection électriquement isolant (190), ledit composant électrique comprenant des premier et deuxième contacts électriques sur ladite au moins une surface, ledit matériau recouvrant lesdits premier et deuxième contacts électriques et comprenant un mélange composite hétérogène composé d'une matrice hôte électriquement isolante et d'une charge particulaire de permittivité diélectrique relative supérieure à celle de la matrice hôte, ledit matériau étant **caractérisé en ce qu'**il comprend une partie composite (191) faiblement concentrée en particules et des première et deuxième couches de relaxation de champ électrique (192₁, 192₂), plus fortement chargées en particules, s'étendant en surface respectivement desdits premier et deuxième contacts électriques.

11. Composant électrique selon la revendication 10, **caractérisé en ce que** lesdites première et deuxième couches de relaxation (192₁, 192₂) présentent une épaisseur sensiblement identique.

12. Composant électrique selon la revendication 10, **caractérisé en ce que** lesdites première et deuxième couches de relaxation (192₁, 192₂) présentent une épaisseur différente.

13. Dispositif de traitement d'un matériau de protection électriquement isolant destiné à recouvrir au moins une surface d'un composant électrique à isoler comprenant des premier et deuxième contacts électriques, le dispositif comprenant :
- des moyens configurés pour mélanger une matrice hôte électriquement isolante avec une charge particulaire de permittivité diélectrique supérieure à celle de la matrice hôte, de façon à obtenir un mélange composite homogène ;
- des moyens configurés pour recouvrir le mélange composite homogène sur ladite au moins une surface du composant électrique à isoler ;
le dispositif étant **caractérisé en ce qu'**il comprend des moyens (150; 170) configurés pour appliquer un champ électrique alternatif, de fréquence inférieure ou égale à 10 Hz, au mélange composite homogène à l'aide desdits premier et deuxième contacts électriques.

## Patentansprüche

1. Verfahren zur Verarbeitung eines elektrisch isolierenden Schutzmaterials, das dazu bestimmt ist, mindestens eine Oberfläche einer zu isolierenden elektrischen Komponente (100) abzudecken, die einen ersten und einen zweiten elektrischen Kontakt (120; 130) umfasst, wobei das Verfahren die folgenden Schritte umfasst:
- Mischen (20) einer elektrisch isolierenden Host-Matrix mit einer Partikelfüllung mit einer relativen Dielektrizitätskonstante, die höher ist als diejenige der Host-Matrix, derart, dass ein homogenes Kompositgemisch erhalten wird;
- Überziehen (30) der mindestens einen Oberfläche der zu isolierenden elektrischen Komponente mit dem homogenen Kompositgemisch;
wobei das Verfahren **dadurch gekennzeichnet ist, dass** es nach dem Überziehschritt einen Schritt (40) des Anlegens eines elektrischen Wechselfeldes mit Frequenz kleiner oder gleich 10 Hz an das homogene Kompositgemisch mittels des ersten und des zweiten elektrischen Kontakts derart umfasst, dass ein heterogenes Kompositgemisch erhalten wird, das einen Kompositabschnitt (191) mit geringer Partikelkonzentration, und eine erste und eine zweite Schicht (192₁, 192₂) der Relaxation des elektrischen Feldes aufweist, die stärker mit Partikeln beladen sind, welche sich jeweils auf der Oberfläche des ersten und des zweiten elektrischen Kontakts erstrecken.

2. Verfahren nach Anspruch 1, **dadurch gekennzeichnet, dass** es außerdem einen Aushärtschritt (50) des Kompositgemischs nach dem Schritt des Anlegens eines elektrischen Feldes umfasst.

3. Verfahren nach Anspruch 1, **dadurch gekennzeichnet, dass** ein Aushärtschritt (50) des Kompositgemischs während des Schritts des Anlegens eines elektrischen Feldes durchgeführt wird.

4. Verfahren nach einem der Ansprüche 1 bis 3, **dadurch gekennzeichnet, dass** das elektrische Feld mittels eines ersten elektrischen Wechselstromsignals mit vorbestimmter Form angelegt wird, das einem zweiten elektrischen Gleichstromsignal überlagert ist.

5. Verfahren nach einem der Ansprüche 1 bis 4, **dadurch gekennzeichnet, dass** das elektrische Feld mit einer Amplitude kleiner als 2 kV/mm angelegt wird.

6. Verfahren nach einem der Ansprüche 1 bis 5, **dadurch gekennzeichnet, dass** die Host-Matrix eine relative Dielektrizitätskonstante zwischen 1 und 20 aufweist, und dass die Partikelfüllung eine Dielektrizitätskonstante größer als 2 aufweist.

7. Verfahren nach einem der Ansprüche 1 bis 6, **dadurch gekennzeichnet, dass** der Schritt des Anlegens eines elektrischen Feldes mittels eines externen Verbindungsabschnitts der elektrischen Komponente ausgeführt wird, der mit einem der ersten und zweiten elektrischen Kontakte zusammenwirkt.

8. Verfahren nach einem der Ansprüche 1 bis 7, **dadurch gekennzeichnet, dass** der Schritt des Anlegens eines elektrischen Feldes mittels mindestens einer temporären und abnehmbaren Gegenelektrode ausgeführt wird, die dazu bestimmt ist, mit einem des ersten und zweiten elektrischen Kontakts verbunden zu werden.

9. Fertigungsverfahren eines elektrischen Komponents, das einen Schritt der Herstellung eines zu isolierenden elektrischen Komponents umfasst, **dadurch gekennzeichnet, dass** es einen Schritt der Verarbeitung eines elektrisch isolierenden Schutzmaterials nach einem der Ansprüche 1 bis 8 umfasst.

10. Elektrische Komponente, von der mindestens eine Oberfläche mit einem elektrisch isolierenden Schutzmaterial (190) überzogen ist, wobei die elektrische Komponente einen ersten und einen zweiten elektrischen Kontakt auf der mindestens einen Oberfläche umfasst, wobei das Material, mit dem der erste und der zweite elektrischen Kontakt überzogen sind, und ein heterogenes Kompositgemisch umfasst, das aus einer elektrisch isolierenden Host-Matrix und einer Partikelfüllung mit relativer Dielektrizitätskonstante größer als derjenigen der Host-Matrix besteht, wobei das Material **dadurch gekennzeichnet ist, dass** es einen Kompositabschnitt (191) mit geringer Partikelkonzentration, und eine erste und eine zweite Schicht (192₁, 192₂) der Relaxation des elektrischen Feldes aufweist, die stärker mit Partikeln geladen sind, welche sich auf der Oberfläche jeweils des ersten und des zweiten elektrischen Kontakts erstrecken.

11. Elektrische Komponente nach Anspruch 10, **dadurch gekennzeichnet, dass** die erste und die zweite Relaxationsschicht (192₁, 192₂) eine im Wesentlichen identische Dicke aufweisen.

12. Elektrische Komponente nach Anspruch 10, **dadurch gekennzeichnet, dass** die erste und die zweite Relaxationsschicht (192₁, 192₂) eine unterschiedliche Dicke aufweisen.

13. Vorrichtung zur Verarbeitung eines elektrisch isolierenden Schutzmaterials, das dazu bestimmt ist, mindestens eine Oberfläche einer zu isolierenden elektrischen Komponente zu überziehen, die einen ersten und einen zweiten elektrischen Kontakt umfasst, wobei die Vorrichtung umfasst:
- Mittel, die dazu konfiguriert sind, eine elektrisch isolierende Host-Matrix mit einer Partikelfüllung mit relativer Dielektrizitätskonstante, die höher ist als die der Host-Matrix, derart zu mischen, dass ein homogenes Kompositgemisch erhalten wird;
- Mittel, die dazu konfiguriert sind, die mindestens eine Oberfläche der zu isolierenden elektrischen Komponente mit dem homogenen Kompositgemisch zu überziehen;
wobei die Vorrichtung **dadurch gekennzeichnet ist, dass** sie Mittel (150 ; 170) umfasst, die dazu konfiguriert sind, ein elektrisches Wechselfeld mit Frequenz kleiner oder gleich 10 Hz an das homogene Kompositgemisch mit Hilfe des ersten und des zweiten elektrischen Kontakts anzulegen.

## Claims

1. Method for processing an electrically insulating protective material intended for covering at least one surface of an electrical component to be insulated (100) comprising first and second electrical contacts (120; 130), the method comprising the following steps:
- mixing (20) an electrically insulating host matrix with a particulate filler having dielectric permittivity higher than that of the host matrix, so as to obtain a homogeneous composite mixture;
- covering (30) said at least one surface of the electrical component to be insulated with the homogeneous composite mixture;
the method being **characterized in that** it comprises, subsequently to said step for covering, a step for applying (40) an electrical field, of frequency lower than or equal to 10 Hz, to the homogeneous composite mixture by means of the first and second electrical contacts, so as to obtain a heterogeneous mixture having a composite part (191) slightly loaded in particulates and first and second electrical field relaxing layers (192₁, 192₂) more highly loaded in particulates extending in surface respectively of said first and second electrical contacts.

2. Method according to claim 1, **characterized in that** it further comprises a step for hardening (50) the composite mixture subsequently to the step for applying an electrical field.

3. Method according to claim 1, **characterized in that** a step for hardening (50) the composite mixture is implemented during the step for applying an electrical field.

4. Method according to any one of the claims 1 to 3, **characterized in that** the electrical field is applied by means of a first electrical signal of pre-determined shape that is superimposed on a second electrical signal.

5. Method according to any one of the claims 1 to 4, **characterized in that** the electrical field is applied with an amplitude of less than 2 kV/mm.

6. Method according to any one of the claims 1 to 5, **characterized in that** the host matrix has relative dielectric permittivity of 1 to 20 and the particulate filler has a dielectric permittivity higher than 2.

7. Method according to any one of the claims 1 to 6, **characterized in that** said step for applying an electrical field is performed by means of an external connection part of the electrical component cooperating with one of said first and second electrical contacts.

8. Method according to any one of the claims 1 to 7, **characterized in that** said step for applying an electrical field is carried out by means of at least one temporary and detachable counter-electrode intended for electrical connection to one of said first and second electrical contacts.

9. Method for manufacturing an electrical component, comprising a step for making an electrical component to be insulated, **characterized in that** it comprises a step for processing an electrically insulating protective material according to any one of the claims 1 to 8.

10. Electrical component, at least one surface of which is covered with an electrically insulating protective material (190), said electrical component comprising first and second electrical contacts, said material comprising a heterogeneous composite mixture composed of an electrically insulating host matrix and a particulate filler of relative dielectric permittivity higher that of the host matrix, said material being **characterized in that** it comprises a composite part (191) slightly loaded in particulates and first and second relaxation layers (192₁, 192₂) more highly loaded in particulates extending on the surface respectively of said first and second electrical contacts.

11. Electrical component according to claim 10, **characterized in that** said first and second relaxation layers (192₁, 192₂) have a substantially identical thickness.

12. Electrical component according to claim 10, **characterized in that** said first and second relaxation layers (192₁, 192₂) have different thicknesses.

13. Device for processing an electrically insulating protective material intended to cover at least one surface of an electrical component to be insulated comprising first and second electrical contacts, the device comprising:
- means configured to mix an electrically insulating host matrix with a particulate filler of dielectric permittivity higher than that of the host matrix, so as to obtain a homogeneous composite mixture;
- means configured to cover said at least one surface of the electrical component with the homogeneous composite mixture;
the device being **characterized in that** it comprises means (150 ; 170) configured to apply an AC electrical field, of a frequency lower than or equal to that of the homogeneous composite mixture by means of said first and second electrical contacts.
